# EUROPÄISCHE PATENTSCHRIFT

(11) **EP 3 855 146 B1**
(45) Veröffentlichungstag und Bekanntmachung des Hinweises auf die Patenterteilung: **06.11.2024**
(21) Anmeldenummer: 20152983.1
(22) Anmeldetag: 21.01.2020
(51) Int. Cl.: G01K 13/00, G01K 1/024

(54) **VERSORGUNGSEINHEIT ZUM ERZEUGEN ELEKTRISCHER ENERGIE, KÜCHENUTENSIL SOWIE KÜCHENSYSTEM**
SUPPLY UNIT FOR GENERATING ELECTRICAL ENERGY, KITCHEN UTENSIL AND KITCHEN SYSTEM
UNITÉ D'ALIMENTATION PERMETTANT DE PRODUIRE DE L'ÉNERGIE ÉLECTRIQUE, USTENSILE DE CUISINE AINSI QUE SYSTÈME DE CUISINE

(43) Veröffentlichungstag der Anmeldung: 28.07.2021
(73) Patentinhaber: Vorwerk & Co. Interholding GmbH, 42270 Wuppertal (DE)
(72) Erfinder: Landsecker, Kai, 40213 Düsseldorf (DE); Stein, Matthias, 45472 Mülheim an der Ruhr (DE); Thies, Felix, 42115 Wuppertal (DE); Yan, Wenjie, 40549 Düsseldorf (DE); Sernecki, Miron, 58097 Hagen (DE)
(74) Vertreter: Bals & Vogel Patentanwälte PartGmbB

(56) Entgegenhaltungen:
- US-A1- 2015 059 469
- US-A1- 2018 353 003

## Beschreibung

Die Erfindung betrifft eine Versorgungseinheit zum Erzeugen elektrischer Energie, ein Küchenutensil sowie ein Küchensystem.

Bei der Aufbereitung und Zubereitung von Nahrungsmitteln werden unterschiedliche Küchengeräte mit speziellen Temperaturzonen eingesetzt, die sich von der Raumtemperatur unterscheiden. In einem Kühlschrank beispielsweise wird eine Kälte erzeugt, um Lebensmittel länger lagern zu können. Im Backofen wird eine hohe Temperatur erzeugt, um Lebensmittel zu backen. Küchenutensilien, die in diesen speziellen Temperaturzonen verwendet werden sollen, werden daher üblicherweise vollständig für diese Temperaturzonen ausgelegt.

Eine elektrische Energieversorgung innerhalb der Temperaturzonen ist oft nicht möglich oder aufwendig umzusetzen, wenn etwaige Energiespeicher, wie z.B. Batterien vor den Temperatureinflüssen geschützt werden. Weiterhin sind derartige Temperaturzonen durch eine Verkleidung des Küchengerätes häufig auch gegenüber Funksignalen abgeschirmt, so dass z.B. eine Überprüfung von Temperaturwerten meist über eine analoge Anzeige erfolgt, die durch ein Sichtfenster, wie ein Backofenfenster, eingesehen werden kann.

Aus dem Dokument US 2015/0059469 A1 ist eine Vorrichtung zur Fernüberwachung flüssiger Lebensmittelprodukte in einem Behälter bekannt.

Es ist eine Aufgabe der vorliegenden Erfindung, voranstehende, aus dem Stand der Technik bekannte Nachteile zumindest teilweise zu beheben. Insbesondere ist es eine Aufgabe der vorliegenden Erfindung eine elektrische Funktion eines Küchenutensils zu ermöglichen, während sich das Küchenutensil zumindest teilweise in einem Temperaturbereich befindet, der sich von der Umgebungstemperatur unterscheidet.

Die voranstehende Aufgabe wird gelöst durch eine Versorgungseinheit mit den Merkmalen des Anspruchs 1, ein Küchenutensil mit den Merkmalen des Anspruchs 12, sowie ein Küchensystem mit den Merkmalen des Anspruchs 15. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Versorgungseinheit beschrieben sind, selbstverständlich auch im Zusammenhang mit dem erfindungsgemäßen Küchenutensil und/oder dem erfindungsgemäßen Küchensystem und jeweils umgekehrt, so dass bezüglich der Offenbarung zu den einzelnen Erfindungsaspekten stets wechselseitig Bezug genommen wird bzw. werden kann.

Gemäß einem ersten Aspekt der Erfindung ist eine Versorgungseinheit zum Erzeugen elektrischer Energie für eine Funktion bei einem Betrieb eines in einem ersten Temperaturbereich anordbaren Funktionselementes eines Küchenutensils vorgesehen. Die Versorgungseinheit weist einen ersten Temperaturabschnitt zur Anordnung in dem ersten Temperaturbereich und einen zweiten Temperaturabschnitt zur Anordnung in einem zweiten Temperaturbereich auf. Der zweite Temperaturbereich weist zum ersten Temperaturbereich eine Temperaturdifferenz auf. Weiterhin weist die Versorgungseinheit ein Bereitstellungsmittel zum Bereitstellen von elektrischer Energie für die Funktion beim Betrieb des Funktionselementes auf. Das Bereitstellungsmittel umfasst ein Umwandlungselement zum Umwandeln von thermischer Energie in elektrische Energie in Abhängigkeit von der Temperaturdifferenz.

Die Versorgungseinheit kann somit auch als Energiebereitstellungseinheit oder Energieversorgungseinheit bezeichnet werden. Die elektrische Funktion kann eine Funktion des Funktionselementes selbst, wie z.B. eine Messfunktion, innerhalb des ersten Temperaturbereiches umfassen. Insbesondere kann die elektrische Funktion den Betrieb des Funktionselementes ermöglichen und z.B. eine Energieversorgung des Funktionselementes umfassen. Es ist jedoch ebenfalls denkbar, dass die elektrische Funktion eine Datenverarbeitung von Daten des Funktionselementes und/oder eine Kommunikation zwischen dem Funktionselement und einem Benutzer oder einer anderen elektrischen Komponente umfasst. Bei dem Küchenutensil kann es sich z.B. um einen Sensor oder ein Messinstrument handeln. Zusätzlich oder alternativ kann das Küchenutensil ferner eine oder mehrere weitere Funktionen zur Zubereitung von Speisen aufweisen. Der erste Temperaturbereich kann eine Wärmezone oder eine Kältezone umfassen. So ist es beispielsweise denkbar, dass die Versorgungseinheit an einem Backofen, einem Topf, einem Kühlschrank oder einer elektrischen Küchenmaschine zum zumindest teilweise automatisierten Zubereiten von Speisen anordbar ist, um die elektrische Funktion beim Betrieb des Funktionselementes zu ermöglichen.

Der erste und zweite Temperaturabschnitt der Versorgungseinheit können mittelbar oder unmittelbar miteinander verbunden sein. Vorzugsweise umfassen beide Temperaturabschnitte ein wärmeleitfähiges Material, wie z.B. ein Metall, um unterschiedliche Temperaturen in dem ersten und zweiten Temperaturbereich zumindest teilweise an das Umwandlungselement weiterleiten zu können. Das Umwandlungselement ist insbesondere derart angeordnet, dass es zumindest teilweise der Temperaturdifferenz zwischen dem ersten und zweiten Temperaturbereich aussetzbar ist. Die Temperaturdifferenz kann durch das Umwandlungselement genutzt werden, um elektrische Energie zu erzeugen und für die Funktion bereitzustellen.

Dadurch kann die Versorgungseinheit für ein Energiemanagement des Küchenutensils einsetzbar sein, während sich das Funktionselement in dem ersten Temperaturbereich befindet. Somit ist es nicht notwendig einen Energiespeicher aufwendig gegen die Temperaturbedingungen im ersten Temperaturbereich abzusichern. Ferner kann eine Verbindung des ersten Temperaturbereiches zum zweiten Temperaturbereich durch die Versorgungseinheit herstellbar sein.

Ferner kann bei einer erfindungsgemäßen Versorgungseinheit vorteilhafterweise vorgesehen sein, dass das Umwandlungselement einen elektrothermischen Wandler aufweist. Bei dem elektrothermischen Wandler kann es sich um ein Halbleiterbauteil, vorzugsweise um ein Peltier-Element, handeln. Insbesondere kann der elektrothermische Wandler auch als thermoelektrischer Generator oder thermoelektrischer Wandler bezeichnet werden. Vorzugsweise kann die elektrische Energie durch den elektrothermischen Wandler unter Ausnutzung des Seebeck-Effektes erzeugbar sein. Dabei kann in Abhängigkeit von der Temperaturdifferenz zwischen dem ersten und zweiten Temperaturbereich und/oder zwischen dem ersten und zweiten Temperaturabschnitt eine elektrische Spannung und/oder ein elektrischer Strom im Umwandlungselement induzierbar sein. Die elektrische Energie kann durch das Bereitstellungsmittel für die elektrische Funktion beim Betrieb des Funktionselementes bereitgestellt werden. Beispielsweise kann die Umwandlungseinheit direkt oder indirekt mit einer elektrischen Komponente verbunden oder verbindbar sein.

Weiterhin ist bei einer erfindungsgemäßen Versorgungseinheit vorgesehen, dass der erste und zweite Temperaturabschnitt durch ein wärmeleitendes Brückenelement verbunden sind, insbesondere wobei das Brückenelement eine Isolationsschicht zur Wärmeisolierung gegenüber einer Umgebung aufweist. Das Brückenelement kann ein wärmeleitfähiges Material umfassen, um einen Wärmeaustausch zwischen dem ersten und zweiten Temperaturabschnitt zu ermöglichen. Die Isolationsschicht umfasst insbesondere ein schwach wärmeleitendes Material. Beispielsweise kann die Isolationsschicht einen Kunststoff aufweisen. Durch die Isolationsschicht kann verhindert werden, dass ein Benutzer, der die Versorgungseinheit anfasst, einer weitergeleiteten Temperatur des ersten Temperaturbereiches ausgesetzt wird. Weiterhin kann dadurch ein Temperaturverlust zwischen dem ersten und zweiten Temperaturbereich reduziert oder verhindert werden. Dadurch kann ein möglichst hoher

Anteil der Temperaturdifferenz das Umwandlungselement erreichen und insbesondere zur Erzeugung der elektrischen Energie nutzbar sein. Vorzugsweise kann das Brückenelement eine flache Erstreckung aufweisen und/oder gebogen ausgeführt sein, um in einer Klappe des Küchengerätes, wie z.B. einer Backofentür, einer Kühlschranktür oder dergleichen, einklemmbar zu sein. Beispielsweise kann das Brückenelement einen Blechkörper umfassen. Die Versorgungseinheit ist durch das Brückenelement am Küchengerät befestigbar.

Weiterhin ist es bei einer erfindungsgemäßen Versorgungseinheit denkbar, dass das Brückenelement zur Anordnung in einem Türbereich eines Küchengerätes ausgebildet ist, so dass der erste Temperaturbereich in einem Innenraum des Küchengerätes und der zweite Temperaturbereich in einem Außenraum anordbar ist, insbesondere wobei das Brückenelement und der erste und zweite Temperaturabschnitt einen u-förmigen Befestigungsabschnitt zur Befestigung der Versorgungseinheit am Küchengerät bilden. Bei dem Innenraum kann es sich z.B. um einen Backraum eines Backofens, einen Garbereich eines Topfes oder eines Behälters einer Küchenmaschine oder einen Kühlbereich eines Kühlschrankes handeln. Der Außenraum kann vorzugsweise eine Umgebungstemperatur, insbesondere Raumtemperatur, aufweisen. Dadurch kann eine vorteilhafte Temperaturdifferenz zur Erzeugung von elektrischer Energie geschaffen sein. Weiterhin kann somit durch die Versorgungseinheit ein eigentlich unzugänglicher erster Temperaturbereich des Küchengerätes auch im Betrieb für die elektrische Funktion erreichbar sein. Durch den u-förmigen Befestigungsabschnitt kann die Versorgungseinheit in eine Klappe des Küchengerätes einhängbar sein. Dadurch kann eine lösbare Befestigungsmöglichkeit geschaffen sein, die aus einer geometrischen Form der Versorgungseinheit resultiert.

Weiterhin ist es bei einer erfindungsgemäßen Versorgungseinheit denkbar, dass das Umwandlungselement am ersten Temperaturabschnitt, am zweiten Temperaturabschnitt und/oder am Brückenelement angeordnet ist. Durch die Anordnung am Brückenelement kann eine Zuleitung von Temperatur aus dem ersten und zweiten Temperaturbereich zum Umwandlungselement von zwei Seiten des Umwandlungselementes erfolgen. Durch die Anordnung am ersten oder zweiten Temperaturabschnitt kann das Umwandlungselement dem ersten oder zweiten Temperaturbereich selbst ausgesetzt sein und über den ersten oder zweiten Temperaturbereich eine Zuleitung der Temperatur des jeweils anderen Temperaturbereiches erfahren. Eine Anordnung im zweiten Temperaturbereich und/oder am Brückenelement hat ferner den Vorteil, dass das Umwandlungselement dem ersten Temperaturbereich nicht vollständig ausgesetzt ist.

Ferner kann bei einer erfindungsgemäßen Versorgungseinheit vorteilhafterweise vorgesehen sein, dass das Bereitstellungsmittel eine zusätzliche Energiequelle zum Bereitstellen von elektrischer Energie, vorzugsweise für die elektrische Funktion und/oder eine weitere Funktion, aufweist, insbesondere wobei das Bereitstellungsmittel ein Schaltelement zum Zuschalten der zusätzlichen Energiequelle zum Bereitstellen von elektrischer Energie aufweist. Die zusätzliche Energiequelle kann einen Energiespeicher, z.B. in Form einer Batterie oder eines Akkumulators, aufweisen. Es ist jedoch ebenfalls denkbar, dass die zusätzliche Energiequelle zumindest ein Photovoltaikmodul, zumindest ein elektroaktives Elastomer und/oder zumindest ein Piezoelement aufweist, um die elektrische Energie zu erzeugen. Durch die zusätzliche Energiequelle kann das Umwandlungselement bei der Bereitstellung elektrischer Energie unterstützbar sein. Es ist jedoch ebenfalls denkbar, dass das Umwandlungselement, insbesondere durch das Schaltelement, abschaltbar ist, so dass die elektrische Energieversorgung für die Funktion für das Küchenutensil und/oder eine weitere elektrische Funktion vollständig durch die Energiequelle bereitgestellt wird. Das Schaltelement kann einen elektrischen Schalter, insbesondere in Form eines Relais oder eines Halbleiterbauteils umfassen.

Es ist ferner bei einer erfindungsgemäßen Versorgungseinheit denkbar, dass eine Elektronikeinheit zur Daten- und/oder Signalverarbeitung für die Funktion des Küchenutensils vorgesehen ist, insbesondere wobei eine Leiterplatte der Elektronikeinheit am zweiten Temperaturabschnitt angeordnet ist. Die Elektronikeinheit kann zumindest ein elektronisches Bauteil für die Daten- und/oder Signalverarbeitung aufweisen. Beispielsweise kann vorgesehen sein, dass durch die Elektronikeinheit analoge Messignale des Funktionselementes digitalisierbar sind. Insbesondere kann das Bereitstellungsmittel zum Bereitstellen der elektrischen Energie für die Elektronikeinheit ausgebildet sein. Somit kann die Daten- und/oder Signalverarbeitung die elektrische Funktion bilden, für welche die elektrische Energie durch das Bereitstellungsmittel bereitstellbar ist. Die Anordnung der Leiterplatte am zweiten Temperaturabschnitt hat den Vorteil, dass die Leiterplatte nicht der Temperatur im ersten Temperaturbereich ausgesetzt ist und somit zum Betrieb bei Raumtemperatur ausgelegt sein kann. Komplexe Schutzmaßnahmen gegen eine Temperatur im ersten Temperaturbereich können folglich entfallen.

Ferner kann bei einer erfindungsgemäßen Versorgungseinheit vorteilhafterweise vorgesehen sein, dass die Elektronikeinheit ein Auswertemodul zum Auswerten von Messsignalen des Küchenutensils, insbesondere des Funktionselementes, aufweist. Insbesondere können Messdaten des Funktionselementes durch die Elektronikeinheit auswertbar oder vorauswertbar sein. Durch die Nähe der Elektronikeinheit zum Funktionselement kann ein Signalweg verkürzt sein, so dass Übertragungsverluste gering gehalten werden können. Weiterhin kann die Versorgungseinheit durch das Auswertemodul eine modulare Schnittstelle bilden, welche mit unterschiedlichen Geräten koppelbar sein kann, um Messdaten zu übertragen. Ferner kann das Küchenutensil, insbesondere die Versorgungseinheit, eine Anzeige aufweisen, über welche die aufbereiteten Messsignale einem Benutzer darstellbar sein können. Vorzugsweise ist das Auswertemodul auf der Leiterplatte am zweiten Temperaturabschnitt angeordnet, um eine temperaturgeschützte Anordnung der Auswerteeinheit zu ermöglichen. Die Auswerteeinheit kann mit dem Bereitstellungsmittel verbunden sein, um durch das Bereitstellungsmittel bestromt zu werden.

Weiterhin ist es bei einer erfindungsgemäßen Versorgungseinheit denkbar, dass das Bereitstellungsmittel ein Verbindungsmittel für eine Verbindung zur Stromübertragung an das Funktionselement und/oder zur Datenkommunikation mit dem Funktionselement aufweist. Insbesondere kann es sich bei der Verbindung zur Stromübertragung um eine, vorzugsweise lösbare, elektrische Verbindung handeln. Das Verbindungsmittel kann elektrische Kontakte, vorzugsweise mit einem Stecker oder einer Steckerbuchse zur lösbaren Kopplung mit dem Funktionselement umfassen. Es ist jedoch ferner denkbar, dass das Verbindungsmittel ein Kabel umfasst, welches das Funktionselement mit dem Bereitstellungsmittel dauerhaft elektrisch verbindet. Durch das Verbindungsmittel kann das Funktionselement im ersten Temperaturbereich durch die von dem Bereitstellungsmittel bereitgestellte elektrische Energie versorgbar sein. Weiterhin kann eine, insbesondere kabelgebundene, Datenkommunikation durch das elektrische Verbindungsmittel ermöglicht sein. Dazu kann das elektrische Verbindungsmittel mehrere Verbindungskontakte zur getrennten Strom- und Signalübertragung aufweisen.

Vorzugsweise kann bei einer erfindungsgemäßen Versorgungseinheit vorgesehen sein, dass das Verbindungsmittel ein Innenkommunikationsmodul für eine drahtlose Datenkommunikation mit dem Funktionselement des Küchenutensils aufweist und/oder dass die Elektronikeinheit ein Außenkommunikationsmodul für eine drahtlose Datenkommunikation mit einem Endgerät aufweist. Unter dem Innenkommunikationsmodul und/oder dem Außenkommunikationsmodul kann jeweils beispielsweise ein WLAN-Modul, ein Bluetooth-Modul, ein NFC-Modul und/oder ein Mobilfunkmodul verstanden werden. Durch die drahtlose Verbindung kann eine Kabelverbindung der Versorgungseinheit zum Endgerät und/oder zum Funktionselement nicht notwendig sein. Unter dem Endgerät kann z.B. ein mobiles Endgerät, wie ein Tablet oder ein Smartphone, eines Benutzers, eine Küchenmaschine oder ein sonstiges zum Datenempfang ausgebildetes elektronisches Gerät verstanden werden. Es kann ferner vorgesehen sein, dass das Innenkommunikationsmodul des Verbindungsmittels dazu ausgebildet ist, elektrische Energie über die drahtlose Datenverbindung zu übertragen. Beispielsweise kann ein RFID-Chip des Funktionselementes durch die drahtlose Datenverbindung bestrombar sein. Dadurch kann eine Kabelverbindung in den ersten Temperaturbereich nicht notwendig sein. Insbesondere kann durch das Innenkommunikationsmodul und das Außenkommunikationsmodul jeweils ein Datenempfang und/oder ein Senden von Daten ermöglicht sein. Das Innenkommunikationsmodul und das Außenkommunikationsmodul können ferner Spulenantennen für die Datenkommunikation aufweisen.

Es ist ferner bei einer erfindungsgemäßen Versorgungseinheit denkbar, dass das Brückenelement eine Signalbrücke zur Weiterleitung von elektrischen Signalen zwischen dem ersten und zweiten Temperaturbereich aufweist. Die Signalbrücke kann vorteilhafterweise ein elektrisch leitendes Material aufweisen, um die elektrischen Signale zwischen dem ersten und zweiten Temperaturbereich zu transportieren. Dabei kann die Signalbrücke mit dem Innenkommunikationsmodul und dem Außenkommunikationsmodul zur Datenkommunikation verbunden sein. Die Signalbrücke kann z.B. ein Kabel oder ein elektrisch leitfähiges Blech umfassen. Weiterhin ist es denkbar, dass sich die Signalbrücke schichtartig entlang des Brückenelementes erstreckt. Somit kann durch die Signalbrücke eine vorteilhafte Möglichkeit geschaffen sein, elektrische Signale in den ersten Temperaturbereich zu transportieren. Beispielsweise ist es denkbar, dass sich der erste Temperaturbereich in einem faradayschen Käfig befindet, welcher gegenüber elektrischen Signalen abgeschirmt ist. Dies kann z.B. der Fall sein, wenn der erste Temperaturbereich durch einen Innenraum eines Backofens gebildet ist. Durch die Signalbrücke kann daher eine Abschirmung des Küchengerätes überwindbar sein. Alternativ ist es denkbar, dass die Kommunikationssignale optisch durch eine Sichtscheibe des Küchengerätes oder zumindest teilweise kabelgebunden über eine elektrische Energieversorgung einer Beleuchtung des Innenraums, wie z.B. eine Backofenbeleuchtung, transportierbar sind, um die Abschirmung zu überwinden.

Gemäß einem weiteren Aspekt der Erfindung ist ein Küchenutensil vorgesehen. Das Küchenutensil weist ein Funktionselement zur Anordnung in einem ersten Temperaturbereich und eine erfindungsgemäße Versorgungseinheit zum Erzeugen elektrischer Energie für eine Funktion bei einem Betrieb des Funktionselementes auf. Die Versorgungseinheit umfasst einen ersten Temperaturabschnitt zur Anordnung in dem ersten Temperaturbereich und einen zweiten Temperaturabschnitt zur Anordnung in einem zweiten Temperaturbereich, der zum ersten Temperaturbereich eine Temperaturdifferenz aufweist. Weiterhin weist die Versorgungseinheit ein Bereitstellungsmittel zum Bereitstellen von elektrischer Energie für die Funktion beim Betrieb des Funktionselementes auf. Das Bereitstellungsmittel umfasst ein Umwandlungselement zum Umwandeln von thermischer Energie in elektrische Energie in Abhängigkeit von der Temperaturdifferenz.

Somit bringt ein erfindungsgemäßes Küchenutensil die gleichen Vorteile mit sich, wie sie bereits ausführlich mit Bezug auf eine erfindungsgemäße Versorgungseinheit beschrieben worden sind. Das Funktionselement und die Versorgungseinheit können eine bauliche Einheit bilden oder modular kombinierbar sein. Insbesondere können das Funktionselement und die Versorgungseinheit baulich getrennt sein und z.B. in Datenkommunikationsverbindung bringbar sein, wenn z.B. die Versorgungseinheit Daten des Funktionselementes verarbeitet. Die Versorgungseinheit kann vorzugsweise mit Funktionselement drahtlos oder kabelgebunden verbindbar oder dauerhaft verbunden sein. Somit kann durch das Küchenutensil eine Verbindung in den ersten Temperaturbereich ermöglicht sein, ohne dass kritische Bauteile der Temperatur im ersten Temperaturbereich ausgesetzt werden.

Weiterhin kann bei einem erfindungsgemäßen Küchenutensil vorteilhafterweise vorgesehen sein, dass das Funktionselement einen Sensor zur Erfassung von Prozessdaten bei der Benutzung des Küchenutensils und/oder eines Küchengerätes aufweist, insbesondere wobei es sich bei dem Sensor um einen Temperatursensor handelt. Somit kann es sich bei dem Funktionselement z.B. um einen Messfühler handeln. Beispielsweise kann es sich bei dem Sensor um einen Thermistor handeln, für den elektrische Energie durch das Bereitstellungsmittel bereitgestellt werden kann. Insbesondere kann es sich bei dem Küchenutensil um ein Fleischthermometer handeln. Bei den Prozessdaten kann es sich z.B. um Gardaten von Speisen handeln, die im ersten Temperaturbereich zubereitet werden. Es ist jedoch ferner denkbar, dass es sich bei den Prozessdaten um Umgebungsdaten im ersten Temperaturbereich handelt. Insbesondere können die Prozessdaten Temperaturdaten und/oder akustische, optische und/oder haptische Daten umfassen. So können z.B. durch das Funktionselement aufgenommene Geräusche oder Lichtspektren im ersten Temperaturbereich auf einen Verschleiß von Komponenten des Küchengerätes oder des Küchenutensils hindeuten. Zusätzlich oder alternativ kann die Versorgungseinheit einen Sensor, insbesondere in Form eines Temperatursensors aufweisen.

Es ist ferner bei einem erfindungsgemäßen Küchenutensil denkbar, dass das Funktionselement und ein Verbindungsmittel der Versorgungseinheit jeweils ein Innenkommunikationsmodul zur, insbesondere drahtlosen, Verbindung des Funktionselementes mit der Versorgungseinheit aufweisen oder dass das Verbindungsmittel einen elektrischen Leiter zur Verbindung des Funktionselementes mit der Versorgungseinheit aufweist. Bei dem elektrischen Leiter kann es sich z.B. um ein Kabel handeln. Weist das Funktionselement selbst ein Innenkommunikationsmodul auf, kann eine Funkverbindung der Versorgungseinheit und des Funktionselementes ermöglicht sein. Durch die Funkverbindung ist eine Kabelverbindung zu dem Funktionselement nicht notwendig.

Gemäß einem weiteren Aspekt der Erfindung ist ein Küchensystem vorgesehen. Das Küchensystem umfasst ein Küchengerät mit einem Innenraum, der gegenüber einem Außenraum eine Temperaturdifferenz aufweist. Ferner umfasst das Küchensystem ein erfindungsgemäßes Küchenutensil, das teilweise im Innenraum und teilweise im Außenraum anordbar ist.

Somit bringt ein erfindungsgemäßes Küchensystem die gleichen Vorteile mit sich, wie sie bereits ausführlich mit Bezug auf eine erfindungsgemäße Versorgungseinheit und/oder ein erfindungsgemäßes Küchenutensil beschrieben worden sind. Bei dem Küchengerät kann es sich z.B. um einen Backofen, einen Topf, einen Kühlschrank, ein Gefrierfach, ein Dampfgarer oder eine elektrische Küchenmaschine zum zumindest teilweise automatisierten Zubereiten von Speisen handeln. Bei dem Innenraum kann es sich um eine Temperaturzone handeln, die kälter oder wärmer ist, als eine Raumtemperatur. Im Außenraum kann beispielsweise eine Umgebungstemperatur oder Raumtemperatur herrschen. Insbesondere kann der Innenraum des Küchengerätes elektrisch abgeschirmt sein. Dabei kann eine Datenkommunikation des Außenraums und des Innenraums über die Versorgungseinheit ermöglicht sein.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen schematisch:
- Figuren 1-2: ein erfindungsgemäßes Küchensystem in unterschiedlichen Ausführungsbeispielen,
- Figuren 3-5: eine erfindungsgemäße Versorgungseinheit in unterschiedlichen Ausführungsbeispielen,
- Figur 6: ein Küchenutensil in einem Beispiel, welches nicht zur beanspruchten Erfindung gehört.

In der nachfolgenden Beschreibung zu einigen Ausführungsbeispielen der Erfindung werden für die gleichen technischen Merkmale auch in unterschiedlichen Ausführungsbeispielen die identischen Bezugszeichen verwendet.

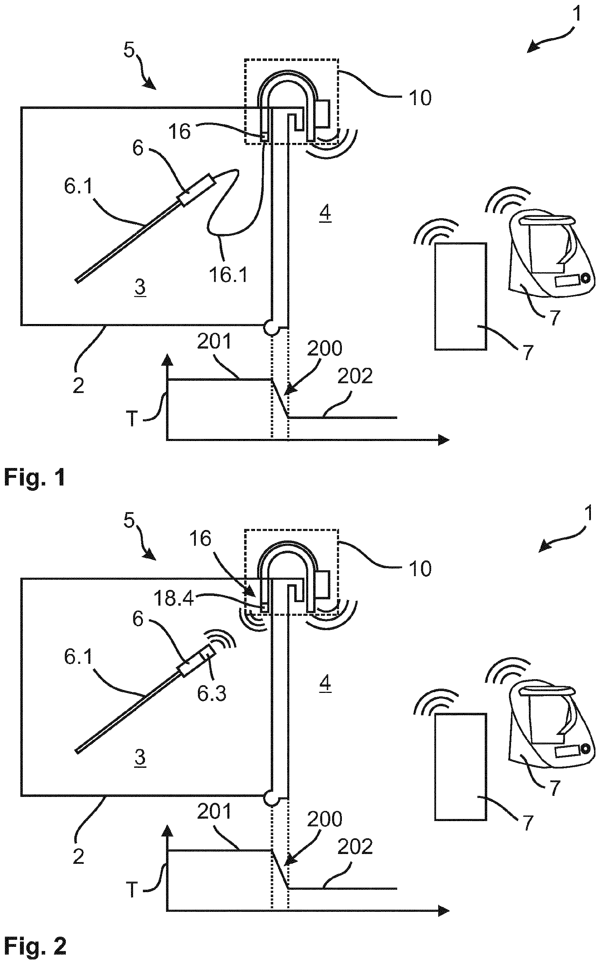

Figur 1 zeigt ein erfindungsgemäßes Küchensystem 1 mit einem Küchengerät 2 und einem erfindungsgemäßen Küchenutensil 5. Bei dem Küchengerät 2 kann es sich z.B. um einen Backofen handeln. Das Küchenutensil 5 weist ein Funktionselement 6 zur Anordnung in einem ersten Temperaturbereich 201 und eine Versorgungseinheit 10 zum Erzeugen elektrischer Energie auf. Die Versorgungseinheit 10 erstreckt sich dabei teilweise in einen Innenraum 3 und teilweise in einen Außenraum 4 des Küchengerätes 2. Im Innenraum 3 herrscht eine gegenüber dem Außenraum 4 erhöhte Temperatur T, wie durch das in Figur 1 dargestellte Diagramm gezeigt. Durch den Innenraum 3 ist der erste Temperaturbereich 201 gebildet und durch den Außenraum 4 ist ein zweiter Temperaturbereich 202 gebildet. Der erste und zweite Temperaturbereich 201, 202 weisen zueinander eine Temperaturdifferenz 200 auf. Vorzugsweise herrscht im Außenraum 4 Raumtemperatur. Bei dem Außenraum 4 handelt es sich insbesondere um eine Umgebung des Küchengerätes 2. Es ist jedoch ebenso denkbar, dass die Temperatur T im Innenraum 3 niedriger ist, als im Außenraum 4, wenn es sich bei dem Küchengerät 2 z.B. um einen Kühlschrank handelt. Das Funktionselement 6 ist im ersten Temperaturbereich 201 angeordnet und weist einen Sensor 6.1, insbesondere in Form eines Temperatursensors, auf. Bei dem Funktionselement 6 kann es sich somit z.B. um einen Messfühler zur Temperaturmessung im Innenraum 3 handeln. Weiterhin ist das Funktionselement 6 mit der Versorgungseinheit 10 über ein Verbindungsmittel 16, insbesondere in Form eines lösbaren elektrischen Leiters 16.1 und eines Steckers, elektrisch verbunden. Darüber hinaus ist die Versorgungseinheit 10 für eine drahtlose Datenkommunikation mit einem Endgerät 7 eines Benutzers ausgebildet. Bei dem Endgerät 7 kann es sich um eine elektromotorische Küchenmaschine oder ein Smartphone handeln. Insbesondere kann die Versorgungseinheit 10 zur Kommunikation mit unterschiedlichen Endgeräten 7 ausgebildet sein. Durch die drahtlose Datenkommunikation können einem Benutzer Sensordaten des Sensors 6.1 des Funktionselementes 6 zur Verfügung gestellt werden.

Zusätzlich oder alternativ zur kabelgebundenen Verbindung können die Versorgungseinheit 10 und das Funktionselement 6 jeweils ein Innenkommunikationsmodul 6.3, 18.4 zur Stromübertragung von der Versorgungseinheit 10 an das Funktionselement 6 und/oder zur Datenkommunikation der Versorgungseinheit 10 mit einem Funktionselement 6 aufweisen, wie in Figur 2 dargestellt.

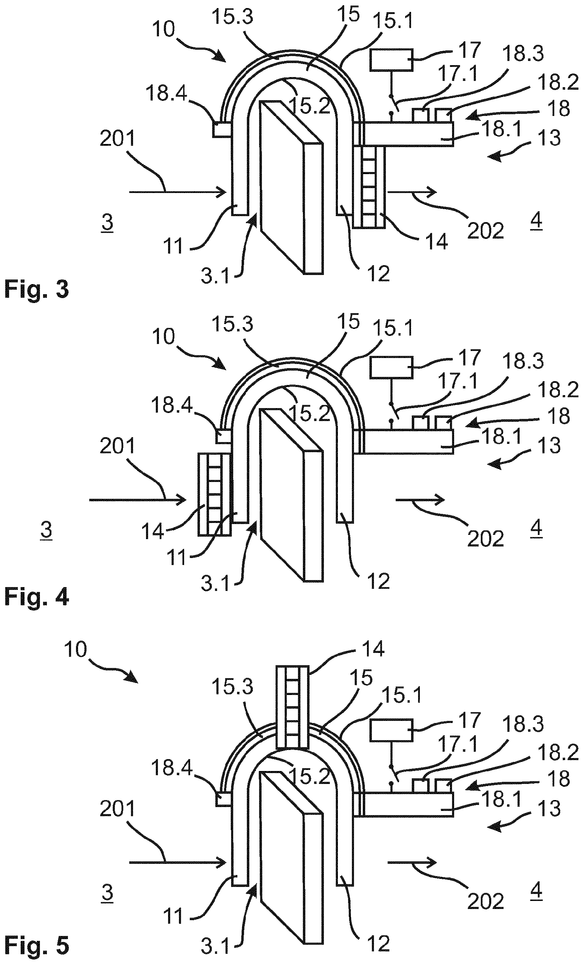

Die Versorgungseinheit 10 ist in Figur 3 im Detail dargestellt. Dabei weist die Versorgungseinheit 10 einen ersten Temperaturabschnitt 11 zur Anordnung im ersten Temperaturbereich 201 und einen zweiten Temperaturabschnitt 12 zur Anordnung im zweiten Temperaturbereich 202 auf. Somit ist die Versorgungseinheit 10 beiden Temperaturbereichen 201, 202 ausgesetzt. Zur Verbindung des ersten und zweiten Temperaturabschnittes 11, 12 weist die Versorgungseinheit 10 ferner ein Brückenelement 15 auf. Das Brückenelement 15 und der erste und zweite Temperaturabschnitt 11, 12 bilden einen u-förmigen Befestigungsabschnitt 15.2 zur Befestigung der Versorgungseinheit 10 am Küchengerät 2. Dadurch kann die Versorgungseinheit 10 z.B. über einen Türbereich 3.1 des Küchengerätes 2 gehangen werden und/oder in einem Türspalt angeordnet werden, um die Verbindung zwischen dem Innenraum 3 und dem Außenraum 4 zu gewährleisten. Vorzugsweise weist das Brückenelement 15 ferner eine Isolationsschicht 15.1 zur Wärmeisolierung gegenüber einer Umgebung auf. Dadurch kann ein Wärmeverlust beim Wärmetransport zwischen dem ersten und zweiten Temperaturabschnitt 11, 12 reduziert oder unterbunden werden. Weiterhin kann dadurch ein Benutzer vor zu großer Hitze geschützt werden.

Zum Bereitstellen von elektrischer Energie für eine elektrische Funktion bei einem Betrieb des Funktionselementes 6 weist die Versorgungseinheit 10 ein Bereitstellungsmittel 13 auf. Das Bereitstellungsmittel 13 umfasst dabei ein Umwandungselement 14 zum Umwandeln von thermischer Energie in elektrische Energie in Abhängigkeit von der Temperaturdifferenz 200 zwischen dem ersten und zweiten Temperaturbereich 201, 202 bzw. dem ersten und zweiten Temperaturabschnitt 11, 12. Bei dem Umwandlungselement 14 handelt es sich um einen elektrothermischen Wandler, insbesondere in Form eines Peltier-Elementes. Dabei wird Wärme über den ersten Temperaturabschnitt 11 aufgenommen und über das Brückenelement 15 an den zweiten Temperaturabschnitt 12 geleitet. Dadurch entsteht die Temperaturdifferenz 200 zwischen dem ersten und zweiten Temperaturabschnitt 11, 12 zumindest teilweise am Umwandlungselement 14. Dadurch, dass das Umwandlungselement 14 am zweiten Temperaturabschnitt 12 angeordnet ist, ist das Umwandlungselement 14 der Temperaturdifferenz 200 zumindest teilweise oder vollständig ausgesetzt. Die daraus resultierende thermische Energie kann durch das Umwandlungselement 14 in elektrische Energie in Abhängigkeit von der Temperaturdifferenz 200 umgewandelt werden. Dabei wird durch das Umwandlungselement 14 eine elektrische Spannung und/oder ein elektrischer Strom im Bereitstellungsmittel 13 induziert und für die Funktion zur Verfügung gestellt. Im dargestellten Ausführungsbeispiel gemäß Figur 2 handelt es sich bei der Funktion um die Verarbeitung und/oder Weiterleitung von Funksignalen zur drahtlosen Kommunikation des Funktionselementes 6 im ersten Temperaturbereich 201 und einem Endgerät 7 des Benutzers. Dabei kann das Funktionselement 6 über die drahtlose Kommunikation mit Strom versorgt werden, um z.B. eine Messfunktion oder eine Rückmeldefunktion zu ermöglichen. Es ist jedoch ebenfalls denkbar, dass die elektrische Energie lediglich für eine Funktion des Funktionselementes 6, wie z.B. die Messfunktion, bereitgestellt wird. Vorzugsweise ist dabei, wie in Figur 1 dargestellt, eine dauerhafte elektrische Verbindung zwischen der Versorgungseinheit 10 und dem Funktionselement 6 vorgesehen.

Weiterhin weist die Versorgungseinheit 10 eine Elektronikeinheit 18 zur Daten- und/oder Signalverarbeitung für die Funktion des Küchenutensils 5 auf. Die Elektronikeinheit 18 umfasst eine Leiterplatte 18.1, auf welcher ein Auswertemodul 18.2 zum Auswerten von Messsignalen des Funktionselementes 6 des Küchenutensils 5 angeordnet ist. Beispielsweise kann das Auswertemodul 18.2 durch das Umwandlungselement 14 bestrombar sein. Weiterhin weist die Versorgungseinheit 10 ein Außenkommunikationsmodul 18.3 zur drahtlosen Datenkommunikation mit dem Endgerät 7 und ein Innenkommunikationsmodul 18.4 zur drahtlosen Datenkommunikation mit dem Funktionselement 6 auf. Dabei ist das Innenkommunikationsmodul 18.4 zur drahtlosen Datenkommunikation mit dem Funktionselement 6 am ersten Temperaturabschnitt 11 angeordnet. Beispielsweise kann es sich bei dem Innenkommunikationsmodul 18.4 um eine Spulenantenne handeln, insbesondere welche unempfindlich oder weniger empfindlich gegenüber dem ersten Temperaturbereich 201 ist. Die Leiterplatte 18.1 ist insbesondere am zweiten Temperaturabschnitt 12 angeordnet und somit nicht unmittelbar dem ersten Temperaturbereich 201 ausgesetzt. Beispielsweise kann die Leiterplatte 18.1 am zweiten Temperaturabschnitt 12 gegenüber der Wärmeleitung vom ersten Temperaturabschnitt 11 zum zweiten Temperaturabschnitt 12 durch die Isolationsschicht 15.1 geschützt sein. Um Signale vom ersten Temperaturabschnitt 11 zum zweiten Temperaturabschnitt 12 zu übermitteln weist das Brückenelement 15 eine Signalbrücke 15.3 auf. Durch die Signalbrücke 15.3 können elektrische Signale zwischen dem ersten und zweiten Temperaturbereich 201, 202 ausgetauscht werden. Beispielsweise kann durch die Signalbrücke 15.3 eine elektrische Abschirmung des Innenraums 3 überwunden werden. Ferner kann durch die Signalbrücke 15.3 das Innenkommunikationsmodul 18.4 zur drahtlosen Datenkommunikation mit dem Funktionselement 6 mit der Leiterplatte 18.1 und/oder dem Umwandlungselement 14 verbunden sein.

Vorzugsweise weist das Bereitstellungsmittel 13 eine zusätzliche Energiequelle 17 zum Bereitstellen von elektrischer Energie auf. Bei der zusätzlichen Energiequelle 17 kann es sich z.B. um eine Batterie, einen Akkumulator oder dergleichen handeln. Dazu weist das Bereitstellungsmittel 13 ferner ein elektrisches Schaltelement 17.1 zum Zuschalten der zusätzlichen Energiequelle 17 auf. Reicht beispielsweise die Temperaturdifferenz 200 nicht aus, um die benötigte elektrische Energie zu erzeugen, kann die zusätzliche Energiequelle 17 zu dem Umwandlungselement 14 zugeschaltet werden. Es ist jedoch ebenfalls denkbar, dass das Umwandlungselement 14 elektrisch trennbar ist, um ein Bereitstellen elektrischer Energie vollständig durch die zusätzliche Energiequelle 17 zu ermöglichen.

In den Figuren 4 und 5 sind ferner weitere Anordnungsmöglichkeiten des Umwandlungselementes 14 dargestellt. Beispielsweise kann das Umwandlungselement 14 gemäß Figur 4 am ersten Temperaturabschnitt 11 angeordnet sein, so dass eine, vorzugsweise negative, Wärmeleitung vom zweiten Temperaturabschnitt 12 über das Brückenelement 15 zum ersten Temperaturabschnitt 11 erfolgt. Dadurch kann die Temperaturdifferenz 200 am ersten Temperaturabschnitt 11 durch das Umwandungselement 14 abgegriffen werden. Ferner kann das Umwandlungselement 14 gemäß Figur 5 am Brückenelement 15 angeordnet sein, so dass eine, insbesondere negative und/oder positive, Wärmeleitung vom ersten und zweiten Temperaturabschnitt 11, 12 jeweils zum Brückenelement 15 erfolgt und die Temperaturdifferenz 200 durch das Umwandlungselement 14 am Brückenelement 15 abgegriffen wird.

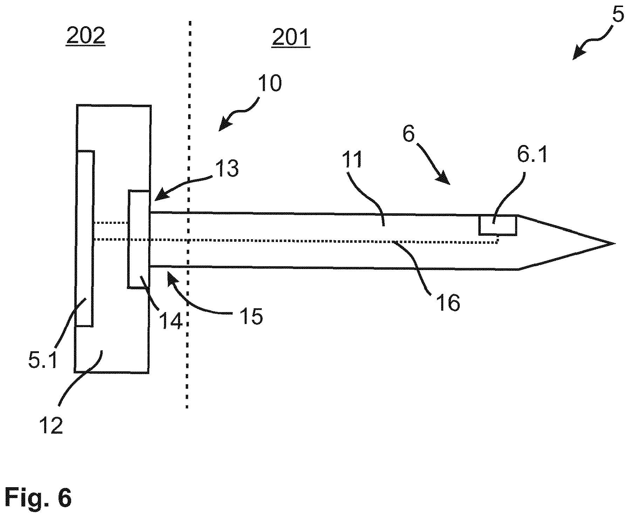

Figur 6 zeigt ein Küchenutensil 5 mit einer Versorgungseinheit 10 zum Erzeugen elektrischer Energie und ein Funktionselement 6, die eine bauliche Einheit bilden. Insbesondere handelt es sich bei dem Küchenutensil 5 um ein Fleischthermometer. Dabei weist die Versorgungseinheit 10 einen ersten Temperaturabschnitt 11 auf, in welchen das Funktionselement 6 integriert ist. Der erste Temperaturabschnitt 11 weist eine nadelartige Form auf, um zusammen mit dem Funktionselement 6 in ein Nahrungsmittel eingestochen zu werden, um dessen Innentemperatur zu erfassen. Innerhalb des Nahrungsmittels kann ein erster Temperaturbereich 201 vorliegen. Dazu weist das Funktionselement 6 einen Sensor 6.1 in Form eines Temperatursensors auf. Die Versorgungseinheit 10 weist ferner ein Bereitstellungsmittel 13 zum Bereitstellen einer elektrischen Funktion für das Küchenutensil 5 auf. Dazu umfasst das Bereitstellungsmittel 13 ein Umwandlungselement 14 in Form eines elektrothermischen Wandlers. Weiterhin umfasst die Versorgungseinheit 10 einen zweiten Temperaturabschnitt 12, der in einem zweiten Temperaturbereich 202 anordbar ist, in welchem eine Temperaturdifferenz 200 zum ersten Temperaturbereich 201 vorliegt. Das Umwandlungselement 14 ist dabei derart zum ersten und zweiten Temperaturabschnitt 11, 12, insbesondere zwischen dem ersten und zweiten Temperaturabschnitt 11, 12, angeordnet, dass das Umwandlungselement 14 der Temperaturdifferenz 200 ausgesetzt ist. Zwischen dem ersten und zweiten Temperaturabschnitt 11, 12 kann ein Brückenelement 15 in Form eines wärmeleitfähigen Abschnitts des Küchenutensils 5 angeordnet sein. In Abhängigkeit von der Temperaturdifferenz 200 ist durch das Umwandlungselement 14 thermische Energie in elektrische Energie umwandelbar. Weiterhin ist ein Verbindungsmittel 16 in Form einer elektrischen Leitung vom Umwandlungselement 14 zum Funktionselement 6 vorgesehen. Dadurch kann die elektrische Energie dem Funktionselement 6 zur Verfügung gestellt werden. Zusätzlich oder alternativ kann durch die elektrische Energie des Umwandungselementes 14 z.B. eine, insbesondere digitale, Anzeige 5.1 des Küchenutensils 5 zur Temperaturanzeige für einen Benutzer bestrombar sein.

### Bezugszeichenliste

- 1: Küchensystem
- 2: Küchengerät
- 3: Innenraum
- 3.1: Türbereich
- 4: Außenraum
- 5: Küchenutensil
- 5.1: Anzeige
- 6: Funktionselement
- 6.1: Sensor
- 6.2: elektrischer Leiter
- 6.3: Innenkommunikationsmodul von 6
- 7: Endgerät

- 10: Versorgungseinheit
- 11: erster Temperaturabschnitt
- 12: zweiter Temperaturabschnitt
- 13: Bereitstellungsmittel
- 14: Umwandlungselement
- 15: Brückenelement
- 15.1: Isolationsschicht
- 15.2: Befestigungsabschnitt
- 15.3: Signalbrücke
- 16: Verbindungsmittel
- 16.1: Leiter
- 17: Energiequelle
- 17.1: Schaltelement
- 18: Elektronikeinheit
- 18.1: Leiterplatte
- 18.2: Auswertemodul
- 18.3: Außenkommunikationsmodul
- 18.4: Innenkommunikationsmodul

- 200: Temperaturdifferenz
- 201: erster Temperaturbereich
- 202: zweiter Temperaturbereich

- T: Temperatur

## Patentansprüche

1. Versorgungseinheit (10) zum Erzeugen elektrischer Energie für eine elektrische Funktion bei einem Betrieb eines in einem ersten Temperaturbereich (201) anordbaren Funktionselementes (6) eines Küchenutensils (5) aufweisend
einen ersten Temperaturabschnitt (11) zur Anordnung in dem ersten Temperaturbereich (201),
einen zweiten Temperaturabschnitt (12) zur Anordnung in einem zweiten Temperaturbereich (202), der zum ersten Temperaturbereich (201) eine Temperaturdifferenz (200) aufweist, und
ein Bereitstellungsmittel (13) zum Bereitstellen von elektrischer Energie für die Funktion beim Betrieb des Funktionselementes (6) mit einem Umwandlungselement (14) zum Umwandeln von thermischer Energie in elektrische Energie in Abhängigkeit von der Temperaturdifferenz (200),
wobei der erste und zweite Temperaturabschnitt (11, 12) durch ein wärmeleitendes Brückenelement (15) verbunden sind,
**dadurch gekennzeichnet,**
**dass** die Versorgungseinheit (10) durch das Brückenelement (15) an einem Küchengerät (2) befestigbar ist.

2. Versorgungseinheit (10) nach Anspruch 1,
**dadurch gekennzeichnet,**
**dass** das Umwandlungselement (14) einen elektrothermischen Wandler aufweist.

3. Versorgungseinheit (10) nach Anspruch 1 oder 2,
**dadurch gekennzeichnet,**
**dass** das Brückenelement (15) eine Isolationsschicht (15.1) zur Wärmeisolierung gegenüber einer Umgebung aufweist.

4. Versorgungseinheit (10) nach einem der vorhergehenden Ansprüche,
**dadurch gekennzeichnet,**
**dass** das Brückenelement (15) zur Anordnung in einem Türbereich (3.1) des Küchengerätes (2) ausgebildet ist, so dass der erste Temperaturbereich (201) in einem Innenraum (3) des Küchengerätes (2) und der zweite Temperaturbereich (202) in einem Außenraum (4) anordbar ist, insbesondere wobei das Brückenelement (15) und der erste und zweite Temperaturabschnitt (11, 12) einen u-förmigen Befestigungsabschnitt (15.2) zur Befestigung der Versorgungseinheit (10) am Küchengerät (2) bilden.

5. Versorgungseinheit (10) nach einem der vorhergehenden Ansprüche,
**dadurch gekennzeichnet,**
**dass** das Umwandlungselement (14) am ersten Temperaturabschnitt (11, 12), am zweiten Temperaturabschnitt (11, 12) und/oder am Brückenelement (15) angeordnet ist.

6. Versorgungseinheit (10) nach einem der vorhergehenden Ansprüche,
**dadurch gekennzeichnet,**
**dass** das Bereitstellungsmittel (13) eine zusätzliche Energiequelle (17) zum Bereitstellen von elektrischer Energie aufweist, insbesondere wobei das Bereitstellungsmittel (13) ein Schaltelement (17.1) zum Zuschalten der zusätzlichen Energiequelle (17) zum Bereitstellen von elektrischer Energie aufweist.

7. Versorgungseinheit (10) nach einem der vorhergehenden Ansprüche,
**dadurch gekennzeichnet,**
**dass** eine Elektronikeinheit (18) zur Daten- und/oder Signalverarbeitung für die Funktion des Küchenutensils (5) vorgesehen ist, insbesondere wobei eine Leiterplatte (18.1) der Elektronikeinheit (18) am zweiten Temperaturabschnitt (12) angeordnet ist.

8. Versorgungseinheit (10) nach einem der vorhergehenden Ansprüche,
**dadurch gekennzeichnet,**
**dass** die Elektronikeinheit (18) ein Auswertemodul (18.2) zum Auswerten von Messsignalen des Küchenutensils (5) aufweist.

9. Versorgungseinheit (10) nach einem der vorhergehenden Ansprüche,
**dadurch gekennzeichnet,**
**dass** das Bereitstellungsmittel (13) ein Verbindungsmittel (16) für eine Verbindung zur Stromübertragung an das Funktionselement (6) und/oder zur Datenkommunikation mit dem Funktionselement (6) aufweist.

10. Versorgungseinheit (10) nach einem der vorhergehenden Ansprüche,
**dadurch gekennzeichnet,**
**dass** das Verbindungsmittel (16) ein Innenkommunikationsmodul (18.4) für eine drahtlose Datenkommunikation mit dem Funktionselement (6) des Küchenutensils (5) aufweist und/oder dass die Elektronikeinheit (18) ein Außenkommunikationsmodul (18.3) für eine drahtlose Datenkommunikation mit einem Endgerät (7) aufweist.

11. Versorgungseinheit (10) nach einem der vorhergehenden Ansprüche,
**dadurch gekennzeichnet,**
**dass** das Brückenelement (15) eine Signalbrücke (15.3) zur Weiterleitung von elektrischen Signalen zwischen dem ersten und zweiten Temperaturbereich (201, 202) aufweist.

12. Küchenutensil (5) aufweisend
ein Funktionselement (6) zur Anordnung in einem ersten Temperaturbereich (201) und eine Versorgungseinheit (10) nach einem der vorhergehenden Ansprüche zum Erzeugen elektrischer Energie für eine elektrische Funktion bei einem Betrieb des Funktionselementes (6).

13. Küchenutensil (5) nach Anspruch 12,
**dadurch gekennzeichnet,**
**dass** das Funktionselement (6) einen Sensor (6.1) zur Erfassung von Prozessdaten bei der Benutzung des Küchenutensils (5) und/oder des Küchengerätes (2) aufweist, insbesondere wobei es sich bei dem Sensor (6.1) um einen Temperatursensor handelt.

14. Küchenutensil (5) nach Anspruch 12 oder 13,
**dadurch gekennzeichnet,**
**dass** das Funktionselement (6) und ein Verbindungsmittel (16) der Versorgungseinheit (10) jeweils ein Innenkommunikationsmodul (6.3, 18.4) zur Verbindung des Funktionselementes (6) mit der Versorgungseinheit (10) aufweisen oder dass das Verbindungsmittel (16) einen elektrischen Leiter (16.1) zur Verbindung des Funktionselementes (6) mit der Versorgungseinheit (10) aufweist.

15. Küchensystem (1) aufweisend
ein Küchengerät (2) mit einem Innenraum (3), der gegenüber einem Außenraum (4) eine Temperaturdifferenz (200) aufweist, und
ein Küchenutensil (5) nach einem der vorhergehenden Ansprüche, das teilweise im Innenraum (3) und teilweise im Außenraum (4) anordbar ist.

## Claims

1. Supply unit (10) for generating electrical energy for an electrical function during operation of a functional element (6) of a kitchen utensil (5) which can be arranged in a first temperature range (201), having
a first temperature section (11) for arrangement in the first temperature region (201),
a second temperature section (12) for arrangement in a second temperature region (202) which has a temperature difference (200) from the first temperature region (201), and
a supply means (13) for supplying electrical energy for the function during operation of the functional element (6) with a conversion element (14) for converting thermal energy into electrical energy as a function of the temperature difference (200),
wherein the first and second temperature sections (11, 12) are connected by a thermally conductive bridge element (15),
**characterized in that**
the supply unit (10) can be attached to a kitchen appliance (2) by the bridge element (15).

2. Supply unit (10) according to claim 1,
**characterized in that**
the conversion element (14) has an electrothermal transducer.

3. Supply unit (10) according to claim 1 or 2,
**characterized in that**
the bridge element (15) has an insulating layer (15.1) for thermal insulation from an environment.

4. Supply unit (10) according to one of the preceding claims,
**characterized in that**
the bridge element (15) is designed for arrangement in a door region (3.1) of the kitchen appliance (2), so that the first temperature region (201) can be arranged in an interior space (3) of the kitchen appliance (2) and the second temperature region (202) can be arranged in an exterior space (4), in particular wherein the bridge element (15) and the first and second temperature sections (11, 12) form a U-shaped fastening section (15.2) for fastening the supply unit (10) to the kitchen appliance (2).

5. Supply unit (10) according to one of the preceding claims,
**characterized in that**
the conversion element (14) is arranged at the first temperature section (11, 12), at the second temperature section (11, 12) and/or at the bridge element (15).

6. Supply unit (10) according to one of the preceding claims,
**characterized in that**
the supply means (13) has an additional energy source (17) for supplying electrical energy, in particular wherein the supply means (13) has a switching element (17.1) for switching on the additional energy source (17) for supplying electrical energy.

7. Supply unit (10) according to one of the preceding claims,
**characterized in that**
an electronics unit (18) is provided for data and/or signal processing for the function of the kitchen utensil (5), in particular wherein a printed circuit board (18.1) of the electronics unit (18) is arranged on the second temperature section (12).

8. Supply unit (10) according to one of the preceding claims,
**characterized in that**
the electronics unit (18) has an evaluation module (18.2) for evaluating measurement signals from the kitchen utensil (5).

9. Supply unit (10) according to one of the preceding claims,
**characterized in that**
the supply means (13) has a connection means (16) for a connection for power transmission to the functional element (6) and/or for data communication with the functional element (6).

10. Supply unit (10) according to one of the preceding claims,
**characterized in that**
the connection means (16) has an internal communication module (18.4) for wireless data communication with the functional element (6) of the kitchen utensil (5) and/or **in that** the electronics unit (18) has an external communication module (18.3) for wireless data communication with a terminal device (7).

11. Supply unit (10) according to one of the preceding claims,
**characterized in that**
the bridge element (15) has a signal bridge (15.3) for forwarding electrical signals between the first and second temperature regions (201, 202).

12. Kitchen utensil (5) comprising
a functional element (6) for arrangement in a first temperature region (201) and
a supply unit (10) according to one of the preceding claims for generating electrical energy for an electrical function during operation of the functional element (6).

13. Kitchen utensil (5) according to claim 12,
**characterized in that**
the functional element (6) has a sensor (6.1) for recording process data during use of the kitchen utensil (5) and/or the kitchen appliance (2), in particular wherein the sensor (6.1) is a temperature sensor.

14. Kitchen utensil (5) according to claim 12 or 13,
**characterized in that**
the functional element (6) and a connection means (16) of the supply unit (10) each have an internal communication module (6.3, 18.4) for connecting the functional element (6) to the supply unit (10), or **in that** the connection means (16) has an electrical conductor (16.1) for connecting the functional element (6) to the supply unit (10).

15. Kitchen system (1) comprising
a kitchen appliance (2) having an interior space (3) which has a temperature difference (200) with respect to an exterior space (4), and
a kitchen utensil (5) according to one of the preceding claims, which can be arranged partly in the interior space (3) and partly in the exterior space (4).

## Revendications

1. Unité d'alimentation (10) pour générer de l'énergie électrique pour une fonction électrique lors d'un fonctionnement d'un élément fonctionnel (6) d'un ustensile de cuisine (5) pouvant être disposé dans une première zone de température (201), présentant
une première section de température (11) destinée à être placée dans la première zone de température (201),
une deuxième section de température (12) destinée à être disposée dans une deuxième zone de température (202) qui présente une différence de température (200) par rapport à la première zone de température (201), et
un moyen de fourniture (13) pour fournir de l'énergie électrique pour la fonction lors du fonctionnement de l'élément fonctionnel (6), comprenant un élément de conversion (14) pour convertir l'énergie thermique en énergie électrique en fonction de la différence de température (200),
dans lequel les première et deuxième sections de température (11, 12) sont reliées par un élément de pont thermiquement conducteur (15),
**caractérisé en ce que**
l'unité d'alimentation (10) peut être fixée par l'élément de pont (15) à un appareil de cuisine (2).

2. Unité d'alimentation (10) selon la revendication 1,
**caractérisé en ce que**
l'élément de conversion (14) comporte un convertisseur électrothermique.

3. Unité d'alimentation (10) selon la revendication 1 ou 2,
**caractérisé en ce que**
l'élément de pont (15) présente une couche d'isolation (15.1) pour l'isolation thermique par rapport à un environnement.

4. Unité d'alimentation (10) selon l'une des revendications précédentes,
**caractérisé en ce que**
l'élément de pont (15) est conçu pour être disposé dans une zone de porte (3.1) de l'appareil de cuisine (2), de sorte que la première zone de température (201) peut être disposée dans un espace intérieur (3) de l'appareil de cuisine (2) et la deuxième zone de température (202) dans un espace extérieur (4), en particulier l'élément de pont (15) et les première et deuxième sections de température (11, 12) formant une section de fixation (15.2) en forme de U pour la fixation de l'unité d'alimentation (10) sur l'appareil de cuisine (2).

5. Unité d'alimentation (10) selon l'une des revendications précédentes,
**caractérisé en ce que**
l'élément de conversion (14) est disposé sur la première section de température (11, 12), sur la deuxième section de température (11, 12) et/ou sur l'élément de pont (15).

6. Unité d'alimentation (10) selon l'une des revendications précédentes,
**caractérisé en ce que**
le moyen de fourniture (13) présente une source d'énergie supplémentaire (17) pour la mise à disposition d'énergie électrique, en particulier le moyen de moyen de fourniture (13) présentant un élément de commutation (17.1) pour la mise en circuit de la source d'énergie supplémentaire (17) pour la mise à disposition d'énergie électrique.

7. Unité d'alimentation (10) selon l'une des revendications précédentes,
**caractérisé en ce qu'**
il est prévu une unité électronique (18) pour le traitement de données et/ou de signaux pour le fonctionnement de l'ustensile de cuisine (5), en particulier une carte imprimée (18.1) de l'unité électronique (18) étant disposée sur la deuxième section de température (12).

8. Unité d'alimentation (10) selon l'une des revendications précédentes,
**caractérisé en ce que**
l'unité électronique (18) présente un module d'évaluation (18.2) pour évaluer des signaux de mesure de l'ustensile de cuisine (5).

9. Unité d'alimentation (10) selon l'une des revendications précédentes,
**caractérisé en ce que**
le moyen de fourniture (13) présente un moyen de liaison (16) pour une liaison pour la transmission de courant à l'élément fonctionnel (6) et/ou pour la communication de données avec l'élément fonctionnel (6).

10. Unité d'alimentation (10) selon l'une des revendications précédentes,
**caractérisé en ce que**
le moyen de liaison (16) présente un module de communication intérieur (18.4) pour une communication de données sans fil avec l'élément fonctionnel (6) de l'ustensile de cuisine (5) et/ou **en ce que** l'unité électronique (18) présente un module de communication extérieur (18.3) pour une communication de données sans fil avec un terminal (7).

11. Unité d'alimentation (10) selon l'une des revendications précédentes,
**caractérisé en ce que**
l'élément de pont (15) présente un pont de signal (15.3) pour la transmission de signaux électriques entre la première et la deuxième zone de température (201, 202).

12. Ustensile de cuisine (5) présentant
un élément fonctionnel (6) destiné à être placé dans une première zone de température (201), et
une unité d'alimentation (10) selon l'une des revendications précédentes pour générer de l'énergie électrique pour une fonction électrique lors d'un fonctionnement de l'élément fonctionnel (6).

13. Ustensile de cuisine (5) selon la revendication 12,
**caractérisé en ce que**
l'élément fonctionnel (6) présente un capteur (6.1) pour la saisie de données de processus lors de l'utilisation de l'ustensile de cuisine (5) et/ou de l'appareil de cuisine (2), en particulier dans lequel le capteur (6.1) est un capteur de température.

14. Ustensile de cuisine (5) selon la revendication 12 ou 13,
**caractérisé en ce que**
l'élément fonctionnel (6) et un moyen de liaison (16) de l'unité d'alimentation (10) présentent chacun un module de communication interne (6.3, 18.4) pour relier l'élément fonctionnel (6) à l'unité d'alimentation (10) ou que le moyen de liaison (16) présente un conducteur électrique (16.1) pour relier l'élément fonctionnel (6) à l'unité d'alimentation (10).

15. Système de cuisine (1) comprenant
un appareil de cuisine (2) avec un espace intérieur (3) qui présente une différence de température (200) par rapport à un espace extérieur (4), et
un ustensile de cuisine (5) selon l'une des revendications précédentes, qui peut être disposé en partie dans l'espace intérieur (3) et en partie dans l'espace extérieur (4).
